(19) Europäisches Patentamt
European Patent Office
Office européen des brevets

(11) Numéro de publication: **0 140 730**
**A1**

(12) # DEMANDE DE BREVET EUROPEEN

(21) Numéro de dépôt: **84401733.5**

(22) Date de dépôt: **29.08.84**

(51) Int. Cl.⁴: **H 01 J 35/00**, H 05 H 1/22

(30) Priorité: **02.09.83 FR 8314086**

(43) Date de publication de la demande: **08.05.85**
**Bulletin 85/19**

(84) Etats contractants désignés: **DE GB IT NL**

(71) Demandeur: **CENTRE NATIONAL DE LA RECHERCHE SCIENTIFIQUE (CNRS), 13 Quai Anatole France, F-75700 Paris (FR)**
Demandeur: **COMMISSARIAT A L'ENERGIE ATOMIQUE Etablissement de Caractère Scientifique Technique et Industriel, 31/33, rue de la Fédération, F-75015 Paris (FR)**

(72) Inventeur: **Doucet, Henri Jean, 3, rue Gometz, F-91470 Les Molieres (FR)**
Inventeur: **Gazaix, Michel, 118, Avenue Saint Exupéry, F-92160 Antony (FR)**
Inventeur: **Lamain, Henri, 92, Avenue du Général de Gaule, F-92140 Clamart (FR)**
Inventeur: **Rouille, Claude, 2, Allée du Pont de Pierre Magny-Les-Hameaux, F-78470 Saint-Remy-Les-Chevreuse (FR)**
Inventeur: **Furtlehner, Jean-Pierre, 7, Parc de Diane, F-78350 Jouy-en-Josas (FR)**

(74) Mandataire: **Mongrédien, André et al, c/o BREVATOME 25, rue de Ponthieu, F-75008 Paris (FR)**

(54) **Source de rayons X mous utilisant un microcanal de plasma obtenu par photoionisation d'un gaz.**

(57) Source intense de rayons X mous.

Cette source comprend une enceinte (14) remplie de gaz et munie de deux électrodes (20, 22). L'une d'entre elles est percée d'un diaphragme (24) par où pénètre un rayonnement photoionisant (30). Selon l'invention, ce rayonnement est un rayonnement X mou, provenant par exemple du bombardement d'une cible (35) en matériau lourd par le rayonnement pulsé d'un laser (32).

Application à la production d'X mous, par exemple pour la microlithographie.

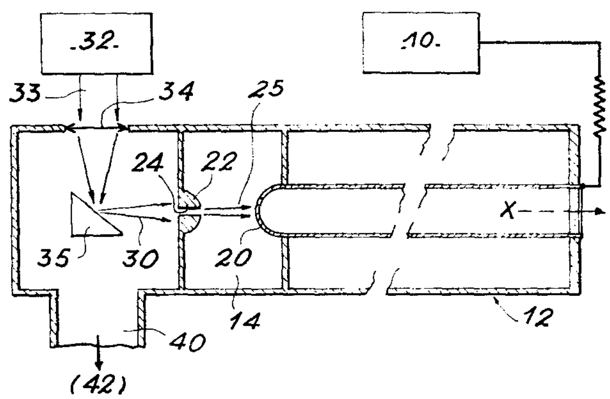


EP 0 140 730 A1

Source de rayons X mous utilisant un microcanal de plasma obtenu par photoionisation d'un gaz.

La présente invention a pour objet une source intense de rayons X mous utilisant un microcanal de plasma obtenu par photoionisation d'un gaz.

Les plasmas dont il est question dans l'invention sont des plasmas chauds et denses. Leur densité électronique est supérieure à environ $10^{18}$ $cm^{-3}$ et leur température électronique tombe dans la plage allant de quelques centaines d'électrons-volts à quelques kilo-électrons volts.

De tels plasmas peuvent constituer des sources intenses de rayonnement X mous. Ces sources présentent, par rapport aux autres sources de rayons X, de nombreux avantages :

- leur coût de réalisation est faible,
- leur encombrement est suffisamment réduit pour qu'elles puissent être placées sur le lieu même de l'utilisation du rayonnement X,
- elles offrent une grande facilité d'utilisation et leur maintenance est aisée,
- leur rendement énergétique est élevé.

Ces avantages rendent de telles sources adaptées à la microlithographie. Elles peuvent constituer également des sources utilisables en microscopie X rapide.

Parmi ces sources, il en est qui mettent en oeuvre une décharge électrique intense à travers un microcanal de plasma, lequel se trouve chauffé par effet Joule et devient le siège d'une émission intense de rayons X mous.

Malgré leur intérêt, ces sources se heurtent à une difficulté qui est la suivante. Un plasma dense et chaud présente une résistivité qui peut être décrite, en l'absence de turbulence ou d'instabilités, par la formule de Spitzer, qui ne dépend que de la température et qui est de la forme :

$$\frac{10^{-3}}{(kT)^{3/2}}$$

en MKSA, où k est la constante de Boltzmann et où T est la température.

La variation de la résistivité en $\frac{1}{T^{3/2}}$ entraîne qu'il est très difficile de chauffer un plasma par effet Joule, car au fur et à mesure que la température augmente, la résistivité baisse et l'effet Joule diminue. Pourtant, ce chauffage reste possible si l'on utilise un microcanal de plasma, c'est-à-dire un canal de très faible diamètre. Cette technique est actuellement utilisée dans une approche particulière de la fusion thermonucléaire contrôlée.

Pour produire un canal de plasma très fin, on utilise actuellement une ionisation par claquage laser d'un gaz à haute pression ou par photoionisation de ce gaz sous l'influence d'un faisceau laser de faible diamètre. Le cordon de plasma ainsi obtenu a un diamètre de quelques centaines de microns. Mais il semble difficile de descendre en-dessous.

Des dispositifs de ce genre ont été décrits par exemple dans la conférence intitulée "Recent results on dense Z pinches" que J.E. HAMMEL et al ont donnée lors de la réunion "Symposium on new trends in unconventional approaches to magnetic fusion" qui s'est tenue au Royal Institute of Technology de Stockholm du 16 au 18 juin 1982.

Dans les travaux actuels sur la fusion thermonucléaire contrôlée une difficulté essentielle est d'obtenir un confinement du plasma dense et chaud pendant un temps suffisant pour satisfaire au critère de Lawson. Dans l'application à la formation de rayonnements X mous, cette difficulté n'apparaît plus, si l'on s'intéresse à des sources pulsées, utilisables par exemple en microlithographie.

La présente invention a pour objet un perfectionnement à ces sources. Le perfectionnement consiste à remplacer le rayonnement optique classique servant à la photoionisation du gaz par un rayonnement X mou. Ce dernier s'avère être beaucoup plus efficace que le rayonnement optique visible, en particulier pour l'ionisation des gaz à haute pression. Dans l'hydrogène, par exemple, la distance d'absorption des photons X mous est de l'ordre de quelques millimètres à la pression atmosphérique. On peut donc les utiliser en les faisant passer à travers un diaphragme de quelques dizaines de microns de diamètre, pour ioniser un microcanal de plasma. Ce dernier est ensuite chauffé par effet Joule, comme dans les sources classiques.

On notera tout d'abord le caractère paradoxal de l'invention, qui recommande d'utiliser des rayons X mous pour alimenter une source dont la finalité est justement l'obtention de rayons X mous. Il y a donc, dans cette démarche, une rupture avec la conception habituelle, qui recommandait l'emploi de moyens d'une autre nature, à savoir de lasers.

Il faut souligner ensuite l'intérêt de l'utilisation de rayons X pour engendrer un microcanal de plasma. Comme la longueur d'onde des rayons X mous utilisés est beaucoup plus faible que celle des rayonnements optiques engendrés par les lasers, les dimensions minimales que l'on peut atteindre, compte tenu des limitations imposées par la diffraction, sont beaucoup plus petites que dans le visible ou le proche ultraviolet. On sait, en effet, que les dimensions de la tache minimale d'un rayonnement sont proportionnelles à la longueur d'onde. Le microcanal de plasma obtenu avec l'invention sera donc de diamètre plus faible que dans l'art antérieur, ce qui est très favorable au processus de chauffage par effet Joule, comme il a été indiqué plus haut.

Dans un mode de réalisation préféré de l'invention, les moyens pour engendrer le rayonnement X mou de photoionisation sont constitués par un laser pulsé tirant sur une cible de métal lourd. On peut utiliser par exemple un laser à rubis tirant sur une cible en plomb.

On notera à nouveau le caractère paradoxal de cette disposition. Alors que, dans l'art antérieur, le rayonnement émis par le laser était envoyé directement dans le gaz pour y provoquer une photoionisation, on préfère, selon l'invention, tirer d'abord sur une cible intermédiaire et utiliser ensuite le rayonnement issu de cette cible. Contrairement à ce que l'on pouvait imaginer, cette étape intermédiaire ajoutée au processus n'est pas nuisible au rendement global de l'opération, bien au contraire, du fait de la plus grande efficacité du rayonnement X dans le mécanisme de photoionisation et de la diminution du diamètre du plasma. Ces deux effets favorables compensent largement la perte d'énergie due à la conversion, sur la cible, du rayonnement optique en rayonnement X. Par ailleurs, la conversion en X mous obtenue par ce processus est relativement importante puisque 10% de l'énergie du rayonnement laser est convertie en rayonnement situé entre 80 et 130 Angströms.

Le comportement d'une cible exposée au rayonnement d'un laser a naturellement déjà fait l'objet de nombreux travaux. L'utilisation du rayonnement réémis par une telle cible à la photoionisation d'un gaz a été décrite par exemple dans l'article de J. BRUNETEAU et E. FABRE intitulé "Photoionisation d'un gaz par le rayonnement ultraviolet extrême d'un plasma créé par laser" et publié dans "Physics Letters", vol.39A, n° 5, 5 juin 1972, pp 411, 412. Mais dans ce cas, c'était le rayonnement ultraviolet extrême (de 85eV à 130eV) émis par la cible qui était utilisé, lequel devait traverser une mince feuille d'or servant de fenêtre et photoioniser un gaz selon un large volume. L'invention adapte ce moyen pour une application nouvelle en introduisant directement le rayonnement X dans la chambre d'ionisation par une ouverture de très petite dimension afin de créer un canal de très faible diamètre et en utilisant un pompage différentiel pour éviter une perte importante du rayonnement ionisant.

L'invention sera mieux comprise à la lecture de la description qui suit, d'exemples de réalisation donnés à titre explicatif et nullement limitatif. Cette description se réfère à des dessins annexés, sur lesquels :

- la figure 1 représente une vue schématique d'une source conforme à l'invention ;
- la figure 2 illustre une variante à ligne plate.

Telle que représentée sur la figure 1, la source comprend, de manière connue, un générateur de haute tension 10 relié à une ligne de transmission 12, une enceinte 14 remplie de gaz et munie de deux électrodes, une cathode 20 et une anode 22, cette dernière étant percée d'une ouverture 24 de faible diamètre.

Conformément à l'invention, le rayonnement 30 de photoionisation qui traverse l'ouverture 24 et crée le microcanal 25, est un rayonnement X mou. Dans la variante illustrée, qui correspond au mode de réalisation préféré de l'invention, les moyens pour produire ce rayonnement X comprennent un laser 32, dont le rayonnement 33 traverse une fenêtre 34 munie d'une lentille de focalisation pour venir frapper une cible 35 en matériau lourd. La face avant de cette cible est orientée de telle sorte que les X mous émis puissent,

en partie, traverser l'orifice 24 percé dans l'anode 22 et servant de diaphragme. Un pompage de l'ensemble s'effectue à travers une tubulure 40, au moyen d'une pompe 42 (non représentée).

De préférence, le laser 32 est un laser à rubis émettant des impulsions d'énergie de l'ordre du Joule et de durée de l'ordre de la dizaine de nanoseconde. La cible est de préférence en plomb. L'enceinte 14 peut contenir de l'hydrogène, sous une pression de 1 atmosphère, par exemple.

Le générateur 10 peut être un générateur de tension continue. Dans ce cas, la décharge principale, à travers le microcanal 25, est déclenchée par l'apparition dudit microcanal, la cellule aux électrodes 20-22 se comportant ainsi comme un véritable éclateur.

Mais le générateur 10 peut être aussi un générateur pulsé. Dans ce cas, il doit être synchronisé sur le laser, comme dans l'art antérieur.

La ligne de transmission 12 peut être une ligne coaxiale (d'impédance 0,5 $\Omega$ par exemple). Mais elle peut aussi être une ligne plate à deux conducteurs, ce qui donne au dispositif une allure particulière qui est représentée sur la figure 2.

La ligne est formée de deux plaques 51, 52, la première s'écartant de la seconde pour constituer l'enceinte 14 remplie de gaz ; cette première plaque est percée d'une ouverture 24 pour laisser pénétrer le faisceau d'X mous 30. Le microcanal 25 s'étend donc de la plaque 51 à la plaque 52. Cette dernière est percée, elle aussi, d'une ouverture 53, pour permettre l'extraction du rayonnement X mou intense produit par la décharge dans le microcanal.

D'autres dispositions peuvent naturellement être imaginées, à partir de diverses lignes de transmission, divers générateurs pulsés ou non, divers lasers ou moyens d'engendrer le rayonnement X initial. A cet égard, il est possible de constituer des sources X en cascade, la première d'entre elles fonctionnant selon le principe des figures 1 et 2, c'est-à-dire avec un laser, mais la seconde et les suivantes utilisant directement le rayonnement X produit par celle qui précède (en totalité ou en partie).

## REVENDICATIONS

1. Source intense de rayons X mous comprenant une enceinte (14) remplie de gaz et munie de deux électrodes (20, 22) reliées à une source de haute tension (10), l'une des électrodes (22) étant percée d'une ouverture (24), un moyen pour engendrer un rayonnement photoionisant (30) dirigé à travers cette ouverture (24), ce rayonnement traversant le gaz en direction de l'autre électrode (20) et créant sur son passage un microcanal de plasma (25), une décharge électrique alimentée par la source (10) se produisant ensuite dans ce microcanal, cette source étant caractérisée par le fait que le moyen pour engendrer le rayonnement photoionisant (30) est une source auxiliaire de rayons X mous.

2. Source selon la revendication 1, caractérisée par le fait que la source auxiliaire de rayons X mous comprend un laser (32) produisant des impulsions de rayonnement optique (33), une cible massive métallique (35) placée sur le trajet du rayonnement (33) émis par le laser, cette cible produisant sous l'effet de ce rayonnement des rayons X mous, la cible étant orientée pour qu'une partie de ces rayons X mous franchisse l'ouverture (24) percée dans l'électrode (22).

3. Source selon la revendication 2, caractérisée par le fait que le laser (32) est un laser à rubis et la cible (35) est en plomb.

4. Source selon la revendication 1, caractérisée par le fait que la source de haute tension (10) est une source continue.

5. Source selon la revendication 1, caractérisée par le fait que la ligne est une ligne plate à deux conducteurs formant l'enceinte.

0140730

1/1

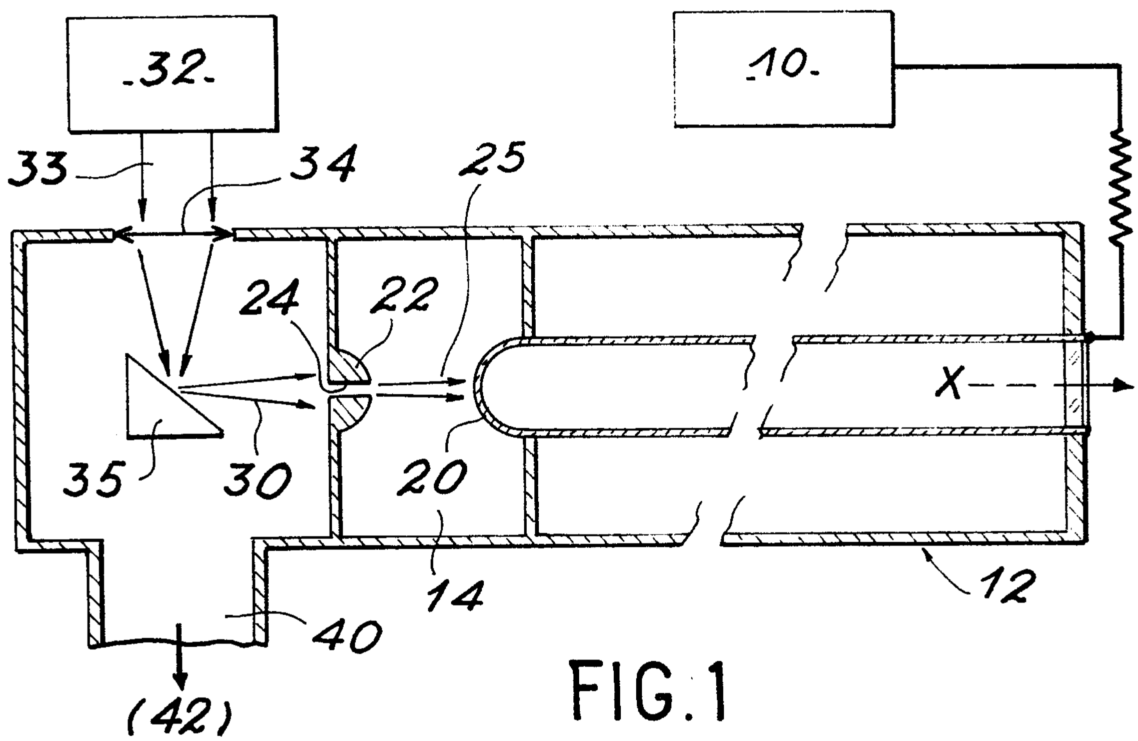


FIG.1

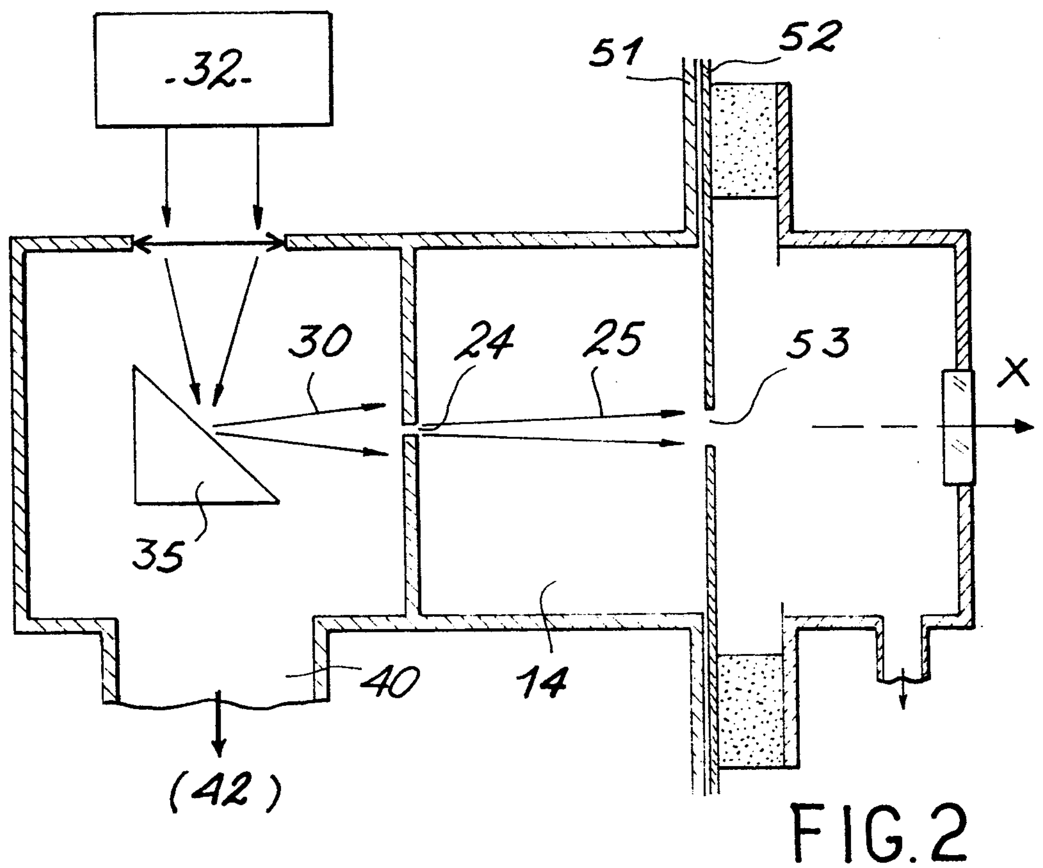


FIG.2

Office européen des brevets

0140730

Numéro de la demande

# RAPPORT DE RECHERCHE EUROPEENNE

EP 84 40 1733

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | US-A-3 746 860 (R.A. SHATAS et al.) * Colonne 1, ligne 65 - colonne 2, ligne 26 * --- | 1,2 | H 01 J 35/00<br>H 05 H 1/22 |
| Y | OPTICS COMMUNICATIONS, vol. 30, no. 2, août 1979, pages 219-223, Amsterdam, NL; S.G. DINEV et al.: "X-ray emission from a laser irradiated target in the presence of high electric field" * Sections 1,2; figure 1 * --- | 1,2 | |
| A | US-A-4 179 599 (R.W. CONRAD) * Abrégé; colonne 1, lignes 11-43 * --- | 1,2 | |
| A | IBM TECHNICAL DISCLOSURE BULLETIN, vol. 18, no. 8, janvier 1976, pages 2731-2732, New York, USA; P.S. ZORY: "Coherent x-ray generator" * page 2731, lignes 3-11; figure 2 * --- -/- | 1,2 | DOMAINES TECHNIQUES RECHERCHES (Int. Cl.4)<br>G 21 K 1/00<br>H 01 J 35/00<br>H 05 G 1/00<br>H 05 H 1/00 |

Le présent rapport de recherche a été établi pour toutes les revendications

| Lieu de la recherche | Date d'achèvement de la recherche | Examinateur |
|---|---|---|
| LA HAYE | 11-12-1984 | HORAK G.I. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82

Office européen des brevets

# RAPPORT DE RECHERCHE EUROPEENNE

0140730

Numéro de la demande

EP 84 40 1733



## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A,D | PHYSICS LETTERS, vol. 39A, no. 5, 5 juin 1972, pages 411-412, Amsterdam, NL; J. BRUNETEAU et al.: "Photoionisation d'un gaz par le rayonnement ultra violet extrême d'un plasma créé par laser" * Page 411, colonne de gauche; lignes 1-19 * ----- | 1,3 | |

DOMAINES TECHNIQUES RECHERCHES (Int. Cl.4)

Le présent rapport de recherche a été établi pour toutes les revendications

| Lieu de la recherche | Date d'achèvement de la recherche | Examinateur |
|---|---|---|
| LA HAYE | 11-12-1984 | HORAK G.I. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82